# EUROPEAN PATENT SPECIFICATION

(11) **EP 2 698 958 B1**
(45) Date of publication and mention of the grant of the patent: **05.12.2018**
(21) Application number: 11746864.5
(22) Date of filing: 18.04.2011
(51) Int. Cl.: H04L 27/00, H04L 27/36, H04L 25/03, H03F 1/32, H04B 1/04, H03F 1/34, H03F 3/24

(54) **DIGITAL ANALOG PREDISTORTION PROCESSING APPARATUS, SIGNAL TRANSMISSION SYSTEM AND SIGNAL TRANSMISSION METHOD**
DIGITALE ANALOGE VORVERZERRUNGSVERARBEITUNGSVORRICHTUNG, SIGNALÜBERTRAGUNGSSYSTEM UND SIGNALÜBERTRAGUNGSVERFAHREN
APPAREIL DE TRAITEMENT DE PRÉ-DISTORSION LORS DE CONVERSION NUMÉRIQUE/ANALOGIQUE, SYSTÈME DE TRANSMISSION DE SIGNAUX ET PROCÉDÉ DE TRANSMISSION DE SIGNAUX

(43) Date of publication of application: 19.02.2014
(73) Proprietor: Huawei Technologies Co., Ltd., Longgang District Shenzhen, Guangdong 518129 (CN)
(72) Inventor: YE, Siqing, Shenzhen Guangdong 518129 (CN); WANG, Wei, Shenzhen Guangdong 518129 (CN); ZHU, Erni, Shenzhen Guangdong 518129 (CN); XU, Shaofeng, Shenzhen Guangdong 518129 (CN)
(74) Representative: Gill Jennings & Every LLP
(86) International application number: PCT/CN2011/072907
(87) International publication number: WO 2011/103822

(56) References cited:
- EP-A1- 1 517 500
- EP-A1- 1 968 201
- WO-A1-01/03287
- CN-A- 1 345 125
- CN-A- 101 022 434
- CN-A- 101 056 288
- US-A1- 2002 034 260
- US-A1- 2009 146 736

## Description

### TECHNICAL FIELD

The present invention relates to the field of communications technologies, and in particular, to a digital analog predistortion processing apparatus, a signal transmission system, and a signal transmission method.

### BACKGROUND

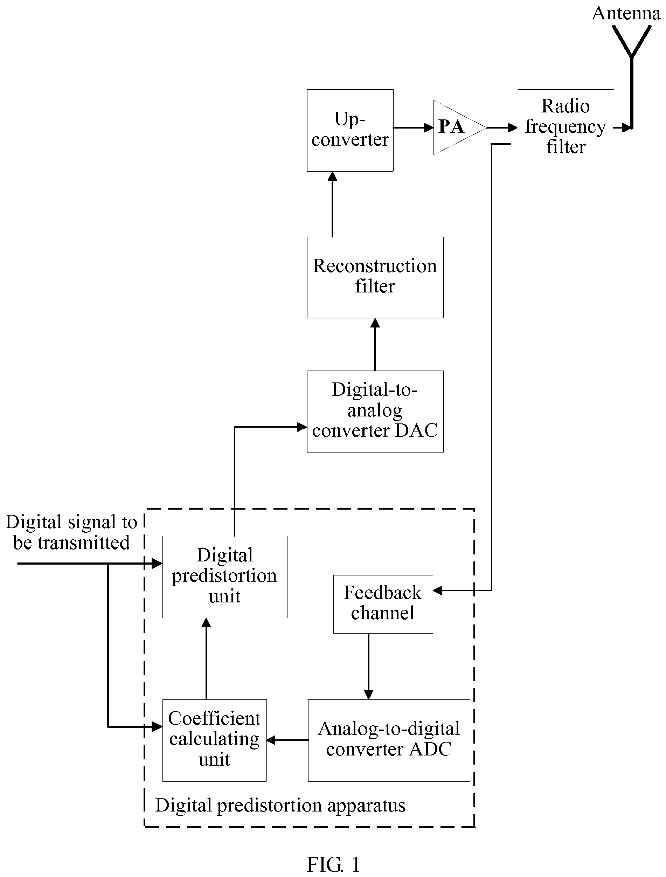

In a wireless signal transmission device such as a base station, the transmission distortion feature of a power amplifier (PA, Power Amplifier) is one of key factors influencing communication quality. Therefore, how to correct PA transmission distortion is a problem which must be considered. Referring to FIG. 1, FIG. 1 shows an existing signal transmission system. A digital signal to be transmitted is divided into two paths, one path enters a coefficient calculating unit, and the other path enters a digital predistortion unit, where the digital predistortion unit performs digital predistortion processing on the input digital signal according to a predistortion coefficient from the coefficient calculating module. Here, the predistortion processing refers to nonlinear processing opposite to the nonlinear feature of a transmission channel formed by an up-converter + a PA. The digital predistortion unit performs predistortion processing on the signal and then outputs a predistortion digital signal; a digital-to-analog converter (DAC, digital-to-analog converter) converts the predistortion digital signal into a low-frequency or intermediate-frequency analog signal, and then a reconstruction filter filters out a digital mirror in a signal output by the DAC after digital-to-analog conversion, and outputs the low-frequency or intermediate-frequency analog signal; then the up-converter converts the low-frequency or intermediate-frequency analog signal into a radio frequency signal, and the radio frequency signal is amplified by the PA and output. The PA nonlinear feature is just opposite to the predistortion feature, so the signal output by the PA can be restored to the signal input by the DAC, namely, restored to a distortionless signal.

A signal output by the PA is divided into two paths, a large part of the signal reaches an antenna after passing through a radio frequency filter, and is transmitted to a wireless space by the antenna; a small part of the signal is sent to a feedback channel through a coupler; in the feedback channel, the signal is down-converted and then sent to an analog-to-digital converter (ADC, analog-to-digital converter), and the ADC converts the signal into a digital signal, namely, a feedback digital signal, and then sends the feedback digital signal to the coefficient calculating unit; the coefficient calculating unit calculates a predistortion coefficient according to the digital signal to be transmitted and the feedback digital signal, and transfers the calculated predistortion coefficient to the digital predistortion unit; the digital predistortion module performs predistortion processing on a subsequently input digital signal to be transmitted according to the predistortion coefficient from the coefficient calculating module, and a cycle can be made accordingly.

During research and practice on the prior art, the inventors find that, a predistortion unit has a feature that an input is a narrow-band signal and an output is a broadband signal, so the bandwidth performance requirement for components such as a DAC and an up-converter is very high if the existing signal transmission system shown in FIG. 1, for example, is adopted. For example, for a signal to be transmitted with bandwidth being 60MHz, if 3rd order inter-modulation (IMD Inter modulation) needs to be corrected, bandwidth of the signal output by the predistortion module is 3*60=180MHz; if 5th order IMD needs to be corrected, bandwidth of the signal output by the predistortion module is 5*60=300MHz; if 7th order IMD needs to be corrected, bandwidth of the signal output by the predistortion module is 7*60=420MHz, and the rest may be deduced by analogy, so the bandwidth requirement for components such as a digital predistortion module, an up-converter, and in particular, a DAC is very high.

United States Patent Application Publication No. 2009/0146736 A1 describes a baseband-derived RF predistortion system using a lookup table having coefficients extracted at baseband and then applied at RF by means of a vector modulator.

United States Patent Application Publication No. 2002/0034260 A1 describes an adaptive predistortion transmitter including a predistortion unit that distorts a digital input signal to have a non-linear characteristic opposite to that of the transmitter.

European Patent Application Publication No. 1968201 A1 describes a method for predistorting an RF signal by means of a predistortion window positioned asymmetrically around the RF signal. European Patent Application Publication No. 1517500 A1 describes a radio transmitter having a filter for filtering a signal to suppress the transmission of parts of the signal outside the band.

### SUMMARY

Embodiments of the present invention provide a digital analog predistortion processing apparatus, a signal transmission system, and a signal transmission method, so as to reduce the high performance requirement of signal predistortion processing on components of the transmission system, thereby reducing the device cost.

In order to solve the foregoing technical problem, the embodiments of the present invention provide the following technical solutions.

A signal transmission system, including:
a first digital-to-analog converter, a reconstruction filter, a digital analog predistortion apparatus, an up-converter, an amplifier, and a radio frequency filter,
where the first digital-to-analog converter is configured to perform digital-to-analog conversion on a digital signal to be transmitted;
the reconstruction filter is configured to filter out a digital mirror in a signal output by the digital-to-analog converter after the digital-to-analog conversion, and output a low-frequency or intermediate-frequency analog signal;
the digital analog predistortion apparatus is configured to perform, according to a predistortion coefficient, analog predistortion processing on the low-frequency or intermediate-frequency analog signal output by the reconstruction filter, and output a low-frequency or intermediate-frequency predistortion analog signal;
the up-converter is configured to perform up-conversion on the low-frequency or intermediate-frequency predistortion analog signal output by the digital analog predistortion apparatus, and output a predistortion radio frequency signal;
the amplifier is configured to amplify the predistortion radio frequency signal output by the up-converter, and output a distortionless radio frequency signal; and the radio frequency filter is configured to perform radio frequency filtering on the distortionless radio frequency signal output by the amplifier and transfer the distortionless radio frequency signal after the radio frequency filtering to an antenna for transmission;
wherein the digital analog predistortion apparatus is further configured to perform down-conversion on a part of the distortionless radio frequency signal output by the amplifier, to obtain a low-frequency or intermediate-frequency feedback analog signal, and perform analog-to-digital conversion on the obtained low-frequency or intermediate-frequency feedback analog signal, to obtain a feedback digital signal;
perform analog-to-digital conversion on a part of the low-frequency or intermediate-frequency analog signal output by the reconstruction filter, to obtain a digital signal; and calculate a predistortion coefficient according to the obtained digital signal and the feedback digital signal.

A digital analog predistortion apparatus, including:
a coefficient calculating unit, an analog predistortion unit, a feedback channel, an analog-to-digital converter, and a second analog-to-digital converter,
where the analog predistortion unit is configured to perform, according to a predistortion coefficient calculated by the coefficient calculating unit, analog predistortion processing on a low-frequency or intermediate-frequency analog signal, and output a low-frequency or intermediate-frequency predistortion analog signal;
the feedback channel is configured to perform down-conversion on a part of a distortionless radio frequency signal output after an amplifier amplifies a predistortion radio frequency signal output by the analog predistortion unit after up-conversion, and output a low-frequency or intermediate-frequency feedback analog signal;
the analog-to-digital converter is configured to perform analog-to-digital conversion on the low-frequency or intermediate-frequency feedback analog signal output by the feedback channel, and output a feedback digital signal;
the second analog-to-digital converter is configured to perform analog-to-digital conversion on a part of the low-frequency or intermediate-frequency analog signal, to obtain a digital signal; and
the coefficient calculating unit is configured to calculate a predistortion coefficient according to the digital signal obtained by the second analog-to-digital converter and the feedback digital signal output by the analog-to-digital converter, and transfer the calculated predistortion coefficient to the analog predistortion unit.

A signal transmission method, including:
performing digital-to-analog conversion on a digital signal to be transmitted;
filtering out a digital mirror in a signal obtained after the digital-to-analog conversion, to obtain a low-frequency or intermediate-frequency analog signal;
performing analog predistortion processing on the obtained low-frequency or intermediate-frequency analog signal according to a predistortion coefficient, to obtain a low-frequency or intermediate-frequency predistortion analog signal;
performing up-conversion on the low-frequency or intermediate-frequency predistortion analog signal, to obtain a predistortion radio frequency signal;
amplifying the obtained predistortion radio frequency signal, to obtain a distortionless radio frequency signal;
performing radio frequency filtering on the obtained distortionless radio frequency signal and transmitting the distortionless radio frequency signal after the radio frequency filtering through an antenna;
performing down-conversion on a part of the obtained distortionless radio frequency signal, to obtain a low-frequency or intermediate-frequency feedback analog signal;
performing analog-to-digital conversion on the obtained low-frequency or intermediate-frequency feedback analog signal, to obtain a feedback digital signal;
performing analog-to-digital conversion on a part of the low-frequency or intermediate-frequency analog signal, to obtain a digital signal; and calculating a predistortion coefficient according to the obtained digital signal and feedback digital signal.

It can be seen from the above description that, in a solution provided in the embodiments of the present invention, firstly a digital signal to be transmitted is processed by using a DAC, a reconstruction filter, and an up-converter, to obtain a radio frequency signal, a digital analog predistortion apparatus performs predistortion processing on the obtained radio frequency signal, and then the radio frequency signal after the predistortion processing is amplified and output, so the bandwidth requirement for components such as the DAC, the reconstruction filter, and the up-converter is relatively low, which helps reduce the device cost.

In another technical solution provided in the embodiments of the present invention, firstly a digital signal to be transmitted is processed by using a DAC and a reconstruction filter, to obtain a low-frequency or intermediate-frequency analog signal, then a digital analog predistortion apparatus performs predistortion processing on the obtained low-frequency or intermediate-frequency analog signal, and then the low-frequency or intermediate-frequency analog signal after the predistortion processing is up-converted, amplified, and output, so the bandwidth requirement for components such as the DAC and the reconstruction filter is relatively low, which helps reduce the device cost.

### BRIEF DESCRIPTION OF DRAWINGS

To describe the technical solutions in the embodiments of the present invention or in the prior art more clearly, the following briefly introduces the accompanying drawings required for describing the embodiments or the prior art. The invention is solely defined by the appended claims. In the following, references to embodiments not falling within the scope of the claims are to be understood as examples useful for understanding the invention.
FIG. 1 is a schematic diagram of a signal transmission system according to the prior art;
FIG. 2-a is a schematic diagram of a signal transmission system according to Embodiment 1 of the present invention;

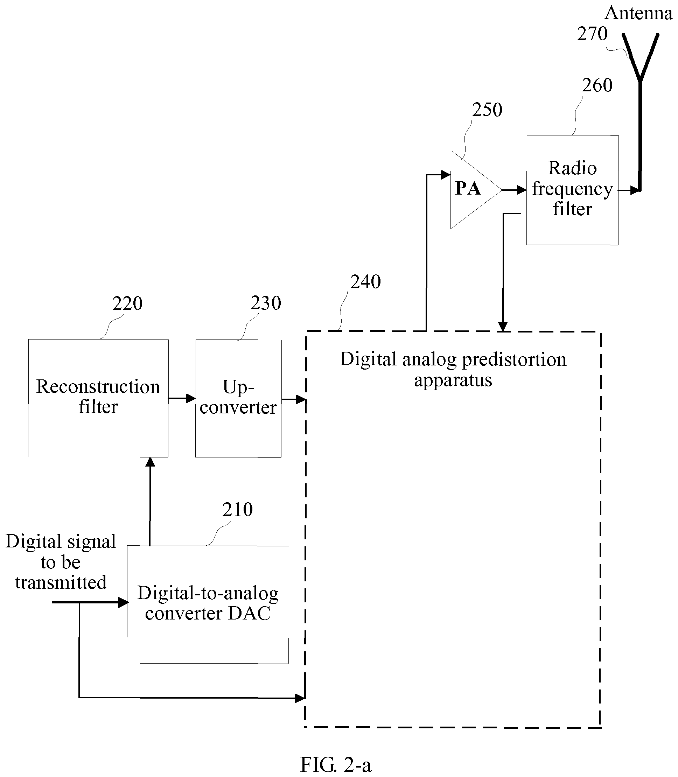

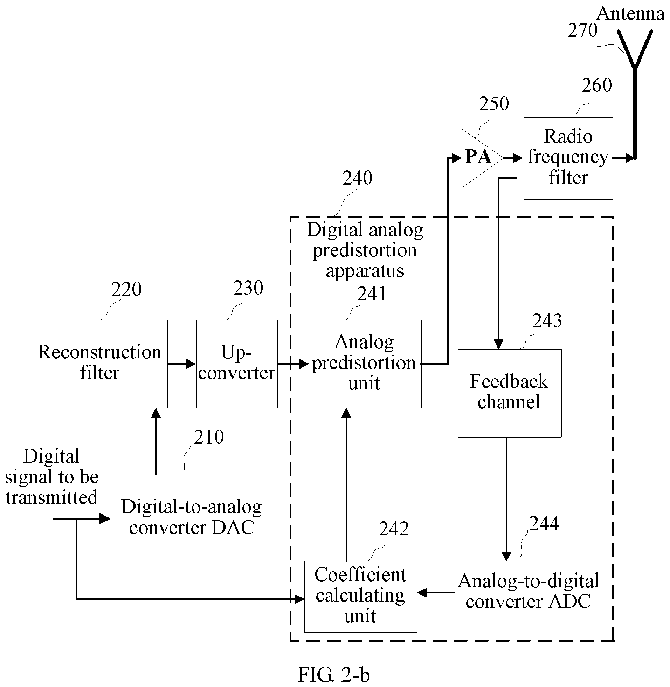

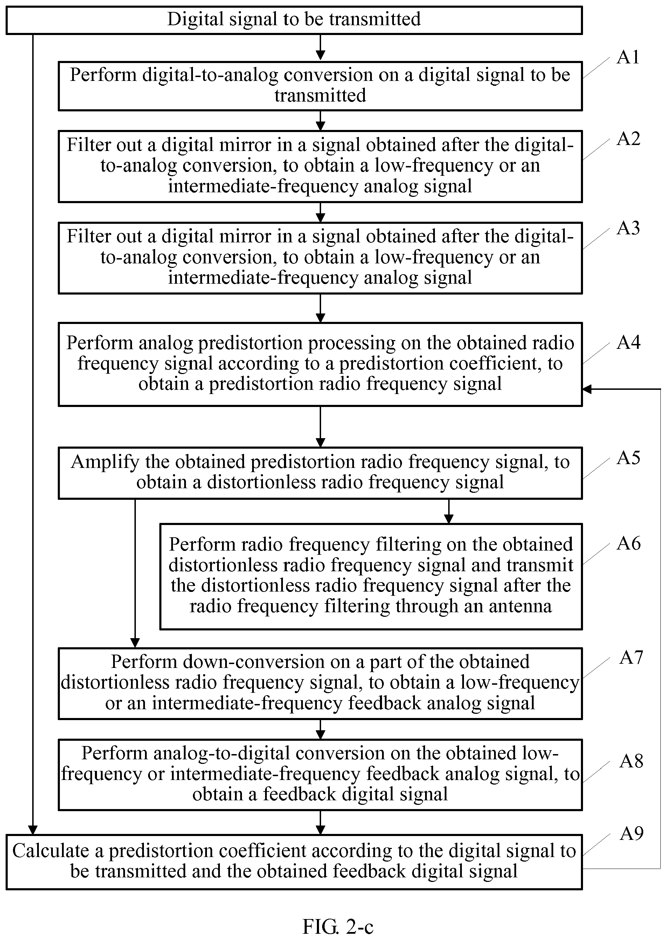

FIG. 2-b is a schematic diagram of another signal transmission system according to Embodiment 1 of the present invention;
FIG. 2-c is a schematic flowchart of a signal transmission method according to Embodiment 1 of the present invention;

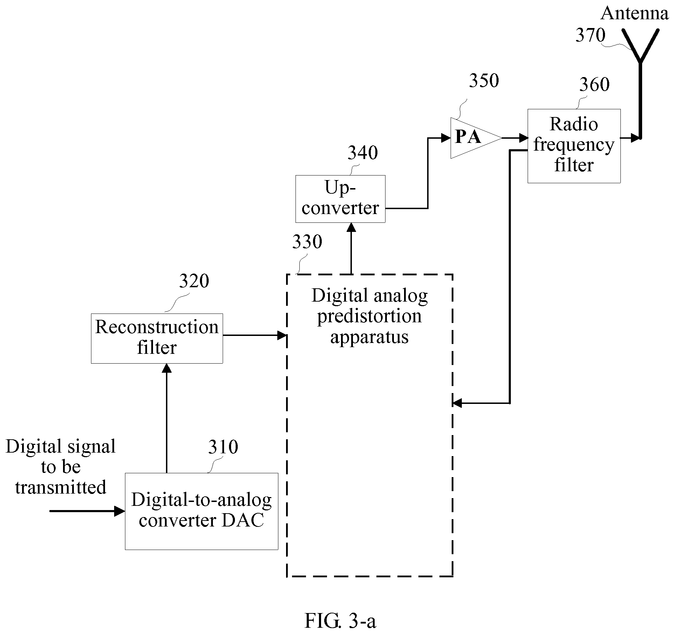

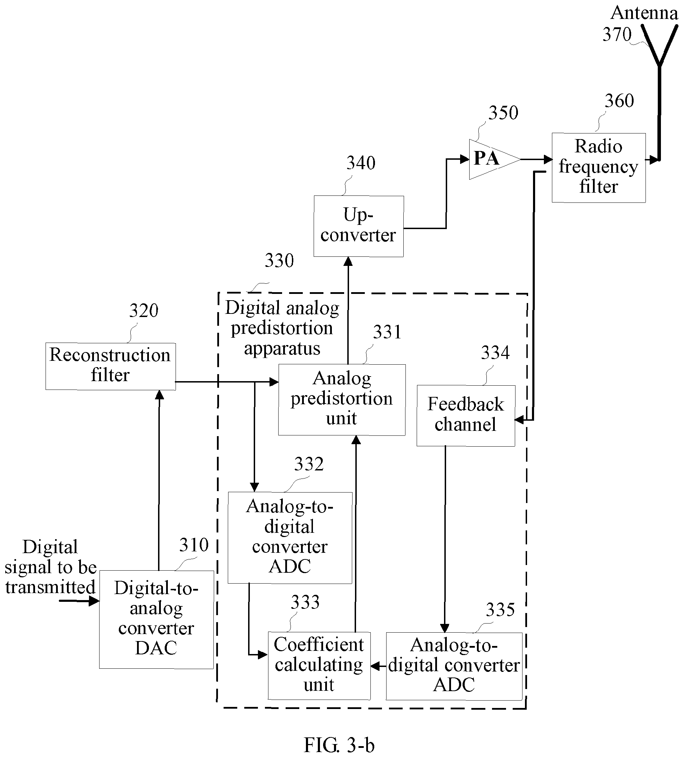

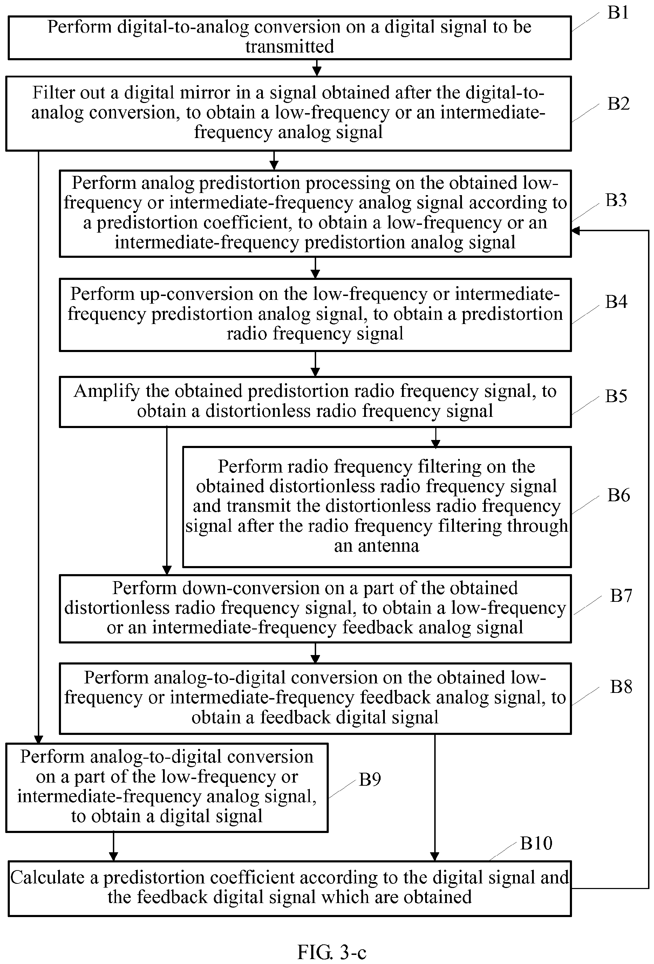

FIG. 3-a is a schematic diagram of a signal transmission system according to Embodiment 2 of the present invention;
FIG. 3-b is a schematic diagram of another signal transmission system according to Embodiment 2 of the present invention; and
FIG. 3-c is a schematic flowchart of a signal transmission method according to Embodiment 2 of the present invention.

### DESCRIPTION OF EMBODIMENTS

Embodiments of the present invention provide a digital analog predistortion processing apparatus, a signal transmission system, and a signal transmission method.

Detailed introduction is made below separately.

To make the solutions of the present invention more comprehensible for a person skilled in the art, the following clearly and completely describes the technical solutions in the embodiments of the present invention with reference to the accompanying drawings in the embodiments of the present invention. Apparently, the described embodiments are merely a part rather than all of the embodiments of the present invention. All other embodiments obtained by a person of ordinary skill in the art based on the embodiments of the present invention without creative efforts shall fall within the protection scope of the present invention.

### Embodiment 1

In an embodiment of a signal transmission system of the present invention, a signal transmission system may include:
a digital-to-analog converter, a reconstruction filter, an up-converter, a digital analog predistortion apparatus, an amplifier, and a radio frequency filter,
where the digital-to-analog converter is configured to perform digital-to-analog conversion on a digital signal to be transmitted;
a reconstruction filter, configured to filter out a digital mirror in a signal output by the digital-to-analog converter after the digital-to-analog conversion, and output a low-frequency or intermediate-frequency analog signal;
an up-converter, configured to up-convert the low-frequency or intermediate-frequency analog signal output by the reconstruction filter, and output a radio frequency signal;
a digital analog predistortion apparatus, configured to perform, according to a predistortion coefficient (the predistortion coefficient may be currently latest obtained or preconfigured (such as an empirical value)), analog predistortion processing on the radio frequency signal output by the up-converter, and output a predistortion radio frequency signal;
the amplifier is configured to amplify the predistortion radio frequency signal output by the analog predistortion apparatus, and output a distortionless radio frequency signal; and
the radio frequency filter is configured to perform radio frequency filtering on the distortionless radio frequency signal output by the amplifier and transfer the distortionless radio frequency signal after the radio frequency filtering to an antenna for transmission.

In an actual application, the digital analog predistortion apparatus may be further configured to perform down-conversion on a part of the distortionless radio frequency signal output by the amplifier, to obtain a low-frequency or intermediate-frequency feedback analog signal, and perform analog-to-digital conversion on the obtained low-frequency or intermediate-frequency feedback analog signal, to obtain a feedback digital signal; and calculate a predistortion coefficient according to the digital signal to be transmitted and the feedback digital signal (the predistortion coefficient can be used during subsequent analog predistortion processing).

In an application scenario, the digital analog predistortion apparatus may include:
a coefficient calculating unit, an analog predistortion unit, a feedback channel, and an analog-to-digital converter,
where the analog predistortion unit is configured to perform, according to a predistortion coefficient calculated by the coefficient calculating unit (where the predistortion coefficient may be a latest predistortion coefficient transferred by the coefficient calculating unit to the analog predistortion unit, and the coefficient calculating unit may calculate the predistortion coefficient according to a previous related signal), analog predistortion processing on the radio frequency signal output by the up-converter, and output a predistortion radio frequency signal;
the feedback channel is configured to perform down-conversion on a part of the distortionless radio frequency signal output by the amplifier, and output a low-frequency or intermediate-frequency feedback analog signal;
the analog-to-digital converter is configured to perform analog-to-digital conversion on the low-frequency or intermediate-frequency feedback analog signal output by the feedback channel, and output a feedback digital signal; and
the coefficient calculating unit is configured to calculate a predistortion coefficient according to the digital signal to be transmitted and the feedback digital signal, and transfer the calculated predistortion coefficient to the analog predistortion unit.

In an actual application, the calculating, by the coefficient calculating unit, a digital predistortion coefficient according to the digital signal to be transmitted and the feedback digital signal relates to a model and a resolving method, which can be various existing models and resolving methods.

For example, for the model, a simplified Volterra model such as a memory polynomial model can be selected; for the resolving method, a resolving method such as least square (LS, least square), least mean square error (LMS, Least Mean Square), or recursive least square (RLS, Recursive Least Square) can be selected.

For convenience of understanding, the following takes signal transmission systems shown in FIG. 2-a and FIG. 2-b as examples to introduce a working procedure of each module in the signal transmission systems.

Referring to FIG. 2-a, the signal transmission system may include:
a digital-to-analog converter 210, a reconstruction filter 220, an up-converter 230, a digital analog predistortion apparatus 240, an amplifier 250, a radio frequency filter 260, and an antenna 270.

A digital signal to be transmitted is divided into two paths (the content of the two paths of signals is the same, but the signal intensity can be different), one path enters the digital-to-analog converter 210, and the other path enters the digital analog predistortion apparatus 240.

A working procedure of each module of the signal transmission system shown in FIG. 2-a can be described as follows:
For example, the digital-to-analog converter 210 may perform digital-to-analog conversion on the digital signal to be transmitted, and output a low-frequency or intermediate-frequency analog signal which may carry a digital mirror; the reconstruction filter 220 may filter out a digital mirror in a signal output by the digital-to-analog converter after the digital-to-analog conversion, and output a low-frequency or intermediate-frequency analog signal; the up-converter 230 up-converts the low-frequency or intermediate-frequency analog signal output by the reconstruction filter, and outputs a radio frequency signal; then the digital analog predistortion apparatus 240 performs, according to a predistortion coefficient (the predistortion coefficient is previously calculated by the analog predistortion apparatus 240 or preconfigured), analog predistortion processing on the radio frequency signal output by the up-converter, and outputs a predistortion radio frequency signal; then the amplifier 250 amplifies the predistortion radio frequency signal output by the analog predistortion apparatus 240, and outputs a distortionless radio frequency signal.

The predistortion of the digital analog predistortion apparatus 240 has a feature that an input is a narrow-band signal and an output is a broadband signal; while, firstly the digital signal to be transmitted is processed by using the digital-to-analog converter 210, the reconstruction filter 220, and the up-converter 230, to obtain a radio frequency signal, then the digital analog predistortion apparatus 240 performs predistortion processing on the obtained radio frequency signal, and then the radio frequency signal after the predistortion processing is amplified and output, so the bandwidth requirement for the digital-to-analog converter 210, the reconstruction filter 220, and the up-converter 230 is relatively low.

The digital analog predistortion apparatus 240 makes nonlinear processing opposite to the nonlinear feature of a transmission channel including the amplifier 250. The nonlinear feature of the amplifier 250 is just opposite to the predistortion feature, so the radio frequency signal amplified and output by the amplifier 250, can be restored to the radio frequency signal output by the up-converter 230 as much as possible, namely, restored to a distortionless radio frequency signal (it can be understood that, the distortionless radio frequency signal here is relatively distortionless, or has a very low distortion extent, and may be not absolutely distortionless, and the understanding of the distortionless radio frequency signal here is applicable to the whole specification).

The distortionless radio frequency signal output by the amplifier 250 can be divided into two paths, where a large part of the distortionless radio frequency signal enters the radio frequency filter 260, and a small part of the distortionless radio frequency signal enters the digital analog predistortion apparatus 240 through coupling; the radio frequency filter 260 performs radio frequency filtering on the distortionless radio frequency signal output by the amplifier 250, and transfers the signal after the radio frequency filtering to the antenna 270 for transmission, and the antenna 270 transmits the signal.

The digital analog predistortion apparatus 240 performs down-conversion on a part of the distortionless radio frequency signal output by the amplifier 250, to obtain a low-frequency or intermediate-frequency feedback analog signal, and performs analog-to-digital conversion on the obtained low-frequency or intermediate-frequency feedback analog signal, to obtain a feedback digital signal; and calculates a predistortion coefficient according to the digital signal to be transmitted and the feedback digital signal, where the predistortion coefficient can be used when the digital analog predistortion apparatus 240 subsequently performs analog predistortion processing. As shown in FIG. 2-b, the digital analog predistortion apparatus 240 may include: an analog predistortion unit 241, a coefficient calculating unit 242, a feedback channel 243, and an analog-to-digital converter 244. A working procedure of each module of the digital analog predistortion apparatus 240 shown in FIG. 2-a can be described as follows:

The analog predistortion unit 241 may perform, according to a predistortion coefficient calculated by the coefficient calculating unit 242 (where the predistortion coefficient may be a latest predistortion coefficient transferred by the coefficient calculating unit 242 to the analog predistortion unit 241, and the coefficient calculating unit 242 may calculate the predistortion coefficient according to a previous related signal; the predistortion coefficient used at this time may also be preconfigured such as an empirical value), analog predistortion processing on the radio frequency signal, and output a predistortion radio frequency signal; the feedback channel 243 performs down-conversion on a part of a distortionless radio frequency signal output after an amplifier 250 amplifies the predistortion radio frequency signal output by the analog predistortion unit 241, and outputs a low-frequency or intermediate-frequency feedback analog signal; then the analog-to-digital converter 244 performs analog-to-digital conversion on the low-frequency or intermediate-frequency feedback analog signal output by the feedback channel 243, and outputs a feedback digital signal; then the coefficient calculating unit 242 calculates a predistortion coefficient according to a digital signal to be transmitted and the feedback digital signal, and transfers the calculated predistortion coefficient to the analog predistortion unit 241; then the analog predistortion unit 241 may also perform, according to the predistortion coefficient transferred by the coefficient calculating unit 242, analog predistortion processing on a radio frequency signal subsequently output by the up-converter 230, and a cycle can be made accordingly.

In an actual application, the calculating, by the coefficient calculating unit 242, a digital predistortion coefficient according to a digital signal to be transmitted and the feedback digital signal relates to a model and a resolving method, and various existing models and corresponding resolving methods can be selected.

For example, for the model, a simplified Volterra model such as a memory polynomial model can be selected. For the resolving method, a resolving method such as least square LS, least mean square error LMS, or RLS can be selected.

The embodiment of the present invention further provides a digital analog predistortion apparatus, which may include:
a coefficient calculating unit, an analog predistortion unit, a feedback channel, and an analog-to-digital converter,
where the analog predistortion unit is configured to perform, according to a predistortion coefficient calculated by the coefficient calculating unit, analog predistortion processing on a radio frequency signal, and output a predistortion radio frequency signal; the feedback channel is configured to perform down-conversion on a part of a distortionless radio frequency signal output after an amplifier amplifies the predistortion radio frequency signal output by the analog predistortion unit, and output a low-frequency or intermediate-frequency feedback analog signal; the analog-to-digital converter is configured to perform analog-to-digital conversion on the low-frequency or intermediate-frequency feedback analog signal output by the feedback channel, and output a feedback digital signal; and the coefficient calculating unit is configured to calculate a predistortion coefficient according to a digital signal to be transmitted and the feedback digital signal, and transfer the calculated predistortion coefficient to the analog predistortion unit.

It can be understood that, a part of modules in the signal transmission system and the digital analog predistortion apparatus 240 provided in the embodiment of the present invention are function modules, and several modules can be combined into a module according to needs of an actual application scenario. For example, the reconstruction filter 220 and the up-converter 230 can be combined into a module having functions of the reconstruction filter and the up-converter, and the rest may be deduced by analogy.

The embodiment of the present invention further provides a signal transmission method, which may include:
performing digital-to-analog conversion on a digital signal to be transmitted; filtering out a digital mirror in a signal obtained after the digital-to-analog conversion, to obtain a low-frequency or intermediate-frequency analog signal; performing up-conversion on the obtained low-frequency or intermediate-frequency analog signal, to obtain a radio frequency signal; performing analog predistortion processing on the obtained radio frequency signal according to a predistortion coefficient (the predistortion coefficient used at this time is calculated previously or preconfigured), to obtain a predistortion radio frequency signal; amplifying the obtained predistortion radio frequency signal, to obtain a distortionless radio frequency signal; and performing radio frequency filtering on the obtained distortionless radio frequency signal and transmitting the distortionless radio frequency signal after the radio frequency filtering through an antenna.

It can be seen from the above description that, in this embodiment, digital-to-analog conversion is firstly performed on a digital signal to be transmitted; a digital mirror in a signal obtained after the digital-to-analog conversion is filtered out, to obtain a low-frequency or intermediate-frequency analog signal; then up-conversion is performed on the obtained low-frequency or intermediate-frequency analog signal, to obtain a radio frequency signal; then analog predistortion processing is performed on the obtained radio frequency signal according to a predistortion coefficient, to obtain a predistortion radio frequency signal; the obtained predistortion radio frequency signal is amplified, to obtain a distortionless radio frequency signal; and radio frequency filtering is performed on the obtained distortionless radio frequency signal, and the distortionless radio frequency signal after the radio frequency filtering is transmitted through an antenna, so the bandwidth requirement for components such as the DAC, the reconstruction filter, and the up-converter is relatively low, which helps reduce the device cost.

In an application scenario, the method further includes: performing down-conversion on a part of the obtained distortionless radio frequency signal, to obtain a low-frequency or intermediate-frequency feedback analog signal; performing analog-to-digital conversion on the obtained low-frequency or intermediate-frequency feedback analog signal, to obtain a feedback digital signal; and calculating a predistortion coefficient according to the digital signal to be transmitted and the obtained feedback digital signal.

Referring to FIG. 2-c, specifically the following steps may be included.
A1: Perform digital-to-analog conversion on a digital signal to be transmitted;
A2: Filter out a digital mirror in a signal obtained after the digital-to-analog conversion, to obtain a low-frequency or intermediate-frequency analog signal;
A3: Perform up-conversion on the obtained low-frequency or intermediate-frequency analog signal, to obtain a radio frequency signal;
A4: Perform analog predistortion processing on the obtained radio frequency signal according to a predistortion coefficient, to obtain a predistortion radio frequency signal;
A5: Amplify the obtained predistortion radio frequency signal, to obtain a distortionless radio frequency signal;
A6: Perform radio frequency filtering on the obtained distortionless radio frequency signal and transmit the distortionless radio frequency signal after the radio frequency filtering through an antenna;
A7: Perform down-conversion on a part of the obtained distortionless radio frequency signal, to obtain a low-frequency or intermediate-frequency feedback analog signal;
A8: Perform analog-to-digital conversion on the obtained low-frequency or intermediate-frequency feedback analog signal, to obtain a feedback digital signal; and
A9: Calculate a predistortion coefficient according to the digital signal to be transmitted and the obtained feedback digital signal.

In an actual application, the calculating a digital predistortion coefficient according to the digital signal to be transmitted and the feedback digital signal relates to a model and a resolving method, and various existing models and resolving methods can be selected.

For example, for the model, a simplified Volterra model such as a memory polynomial model can be selected. For the resolving method, a resolving method such as least square LS, least mean square error LMS, or RLS can be selected.

It can be understood that, steps A7 to A9 can be executed at any moment after step A5, for example, can be executed before step A6.

It can be understood that, the foregoing signal transmission method may be specifically implemented based on the signal transmission system shown in FIG. 2-a, and for the specific implementation procedure, reference is made to the description of a related part, which is not described herein again.

It can be seen from the above description that, in this embodiment, firstly a digital signal to be transmitted is processed by using a DAC, a reconstruction filter, and an up-converter, to obtain a radio frequency signal, then a digital analog predistortion apparatus performs predistortion processing on the obtained radio frequency signal, and then the radio frequency signal after the predistortion processing is amplified and output, so the bandwidth requirement for components such as the DAC, the reconstruction filter, and the up-converter is relatively low, which helps reduce the device cost.

### Embodiment 2

In another embodiment of a signal transmission system of the present invention, a signal transmission system may include:
a first digital-to-analog converter, a reconstruction filter, a digital analog predistortion apparatus, an up-converter, an amplifier, and a radio frequency filter,
where the first digital-to-analog converter is configured to perform digital-to-analog conversion on a digital signal to be transmitted;
the reconstruction filter is configured to filter out a digital mirror in a signal output by the digital-to-analog converter after the digital-to-analog conversion, and output a low-frequency or intermediate-frequency analog signal;
the digital analog predistortion apparatus is configured to perform, according to a predistortion coefficient (the predistortion coefficient may be currently latest obtained or preconfigured), analog predistortion processing on the low-frequency or intermediate-frequency analog signal output by the reconstruction filter, and output a low-frequency or intermediate-frequency predistortion analog signal;
the up-converter is configured to perform up-conversion on the low-frequency or intermediate-frequency predistortion analog signal output by the digital analog predistortion apparatus, and output a predistortion radio frequency signal;
the amplifier is configured to amplify the predistortion radio frequency signal output by the up-converter, and output a distortionless radio frequency signal; and the radio frequency filter is configured to perform radio frequency filtering on the distortionless radio frequency signal output by the amplifier and transfer the distortionless radio frequency signal after the radio frequency filtering to an antenna for transmission.

In an actual application, the digital analog predistortion apparatus may be further configured to perform down-conversion on a part of the distortionless radio frequency signal output by the amplifier, to obtain a low-frequency or intermediate-frequency feedback analog signal, and perform analog-to-digital conversion on the obtained low-frequency or intermediate-frequency feedback analog signal, to obtain a feedback digital signal; perform analog-to-digital conversion on a part of the low-frequency or intermediate-frequency analog signal output by the reconstruction filter, to obtain a digital signal; and calculate a predistortion coefficient according to the obtained digital signal and the feedback digital signal (the calculated predistortion coefficient can be used during subsequent analog predistortion processing).

In an application scenario, the digital analog predistortion apparatus may include:
a coefficient calculating unit, an analog predistortion unit, a feedback channel, an analog-to-digital converter, and a second analog-to-digital converter,
where the analog predistortion unit is configured to perform, according to a predistortion coefficient calculated by the coefficient calculating unit (the predistortion coefficient may be a latest predistortion coefficient transferred by the coefficient calculating unit to the analog predistortion unit, and the coefficient calculating unit may calculate the predistortion coefficient according to a previous related signal, or may also be preconfigured), analog predistortion processing on the low-frequency or intermediate-frequency analog signal output by the reconstruction filter, and output a low-frequency or intermediate-frequency predistortion analog signal;
the feedback channel is configured to perform down-conversion on a part of the distortionless radio frequency signal output by the amplifier, and output a low-frequency or intermediate-frequency feedback analog signal;
the analog-to-digital converter is configured to perform analog-to-digital conversion on the low-frequency or intermediate-frequency feedback analog signal output by the feedback channel, and output a feedback digital signal;
the second analog-to-digital converter is configured to perform analog-to-digital conversion on a part of the low-frequency or intermediate-frequency analog signal output by the reconstruction filter, to obtain a digital signal; and
the coefficient calculating unit is configured to calculate a predistortion coefficient according to the digital signal obtained by the second analog-to-digital converter and the feedback digital signal output by the analog-to-digital converter, and transfer the calculated predistortion coefficient to the analog predistortion unit.

In an actual application, the calculating, by the coefficient calculating unit, a predistortion coefficient according to the digital signal obtained by the second analog-to-digital converter and the feedback digital signal output by the analog-to-digital converter relates to a model and a resolving method, and various existing models and corresponding resolving methods can be selected.

For example, for the model, a simplified Volterra model such as a memory polynomial model can be selected. For the resolving method, a resolving method such as least square LS, least mean square error LMS, or RLS can be selected.

For convenience of understanding, the following takes signal transmission systems shown in FIG. 3-a and FIG. 3-b as examples to introduce a working procedure of each module in the signal transmission systems.

Referring to FIG. 3-a, the signal transmission system may include:
a digital-to-analog converter 310, a reconstruction filter 320, a digital analog predistortion apparatus 330, an up-converter 340, an amplifier 350, a radio frequency filter 360, and an antenna 370.

A working procedure of each module of the signal transmission system shown in FIG. 3-a can be described as follows:
For example, the digital-to-analog converter 310 may perform digital-to-analog conversion on a digital signal to be transmitted, and output a low-frequency or intermediate-frequency analog signal which may carry a digital mirror; the reconstruction filter 320 filters out a digital mirror in a signal output by the digital-to-analog converter 310 after the digital-to-analog conversion, and outputs a low-frequency or intermediate-frequency analog signal; the digital analog predistortion apparatus 330 performs, according to a predistortion coefficient (where the predistortion coefficient is previously calculated by the analog predistortion apparatus 330 or preconfigured), analog predistortion processing on the low-frequency or intermediate-frequency analog signal output by the reconstruction filter 320, and outputs a low-frequency or intermediate-frequency predistortion analog signal; the up-converter 340 performs up-conversion on the low-frequency or intermediate-frequency predistortion analog signal output by the digital analog predistortion apparatus 330, and outputs a predistortion radio frequency signal; then the amplifier 350 amplifies the predistortion radio frequency signal output by the up-converter 340, and outputs a distortionless radio frequency signal.

The predistortion processing of the digital analog predistortion apparatus 330 has a feature that an input is a narrow-band signal and an output is a broadband signal; while, firstly the digital signal to be transmitted is processed by using the digital-to-analog converter 310 and the reconstruction filter 320, to obtain a low-frequency or intermediate-frequency analog signal, then the digital analog predistortion apparatus 330 performs predistortion processing on the obtained low-frequency or intermediate-frequency analog signal, and then the low-frequency or intermediate-frequency analog signal after the predistortion processing is up-converted, amplified, and output, so the bandwidth requirement for the digital-to-analog converter 310 and the reconstruction filter 320 is relatively low.

The digital analog predistortion apparatus 330 makes nonlinear processing opposite to the nonlinear feature of a transmission channel including the amplifier 350. The nonlinear feature of the amplifier 350 is just opposite to the predistortion feature, so the radio frequency signal amplified and output by the amplifier 350, can be restored to the radio frequency signal output by the reconstruction filter 320 as much as possible, namely, restored to a distortionless radio frequency signal (it can be understood that, the distortionless radio frequency signal here is relatively distortionless, and may be not absolutely distortionless).

The distortionless radio frequency signal output by the amplifier 350 can be divided into two paths, where a large part of the distortionless radio frequency signal enters the radio frequency filter 360, and a small part of the distortionless radio frequency signal enters the digital analog predistortion apparatus 340 through coupling; the radio frequency filter 360 performs radio frequency filtering on the distortionless radio frequency signal output by the amplifier 350, and transfers the signal after the radio frequency filtering to the antenna 370 for transmission, and the antenna 370 transmits the signal.

The digital analog predistortion apparatus 330 further performs down-conversion on a part of the distortionless radio frequency signal output by the amplifier 350, to obtain a low-frequency or intermediate-frequency feedback analog signal, and performs analog-to-digital conversion on the obtained low-frequency or intermediate-frequency feedback analog signal, to obtain a feedback digital signal; performs analog-to-digital conversion on a part of the low-frequency or intermediate-frequency analog signal output by the reconstruction filter 320, to obtain a digital signal; and calculates a predistortion coefficient according to the obtained digital signal and the feedback digital signal, where the predistortion coefficient can be used when the digital analog predistortion apparatus 330 subsequently performs analog predistortion processing.

As shown in FIG. 3-b, the digital analog predistortion apparatus 330 may include: an analog predistortion unit 331, an analog-to-digital converter 332, a coefficient calculating unit 333, a feedback channel 334, and an analog-to-digital converter 335.

A working procedure of each module of the digital analog predistortion apparatus 3300 shown in FIG. 3-b can be described as follows:
the low-frequency or intermediate-frequency analog signal output by the reconstruction filter 320 can be divided into two paths (the content of the two paths of signals is the same, but the signal intensity may be different), one path enters the analog predistortion unit 331, and the other path enters the analog-to-digital converter 332.

The analog-to-digital converter 332 performs analog-to-digital conversion on a part of the low-frequency or intermediate-frequency analog signal output by the reconstruction filter 320, to obtain a digital signal; the analog predistortion unit 331 may perform, according to a predistortion coefficient calculated by the coefficient calculating unit 333 (where the predistortion coefficient may be a latest predistortion coefficient transferred by the coefficient calculating unit 333 to the analog predistortion unit 331, and the coefficient calculating unit 333 may calculate the predistortion coefficient according to a previous related signal, or the predistortion coefficient may also be preconfigured), analog predistortion processing on the low-frequency or intermediate-frequency analog signal output by the reconstruction filter 320, and output a low-frequency or intermediate-frequency predistortion analog signal; the feedback channel 334 performs down-conversion on a part of a distortionless radio frequency signal output after an amplifier 350 amplifies a predistortion radio frequency signal output by the up-converter 340, and outputs a low-frequency or intermediate-frequency feedback analog signal; then the analog-to-digital converter 335 performs analog-to-digital conversion on the low-frequency or intermediate-frequency feedback analog signal output by the feedback channel 334, and outputs a feedback digital signal.

The coefficient calculating unit 333 calculates a predistortion coefficient according to the digital signal obtained by the analog-to-digital converter 332 and the feedback digital signal output by the analog-to-digital converter 335, and transfers the calculated predistortion coefficient to the analog predistortion unit 331; then the analog predistortion unit 331 may also perform, according to the predistortion coefficient transferred by the coefficient calculating unit 333, analog predistortion processing on a low-frequency or intermediate-frequency analog signal subsequently output by the reconstruction filter 320, and a cycle can be made accordingly.

In an actual application, the calculating, by the coefficient calculating unit 333, a predistortion coefficient according to the digital signal obtained by the analog-to-digital converter 332 and the feedback digital signal output by the analog-to-digital converter 335 relates to a model and a resolving method, and various existing models and corresponding resolving methods can be selected.

For example, for the model, a simplified Volterra model such as a memory polynomial model can be selected. For the resolving method, a resolving method such as least square LS, least mean square error LMS, or RLS can be selected.

The embodiment of the present invention further provides a digital analog predistortion apparatus, which may include: a coefficient calculating unit, an analog predistortion unit, a feedback channel, an analog-to-digital converter, and a second analog-to-digital converter,
where the analog predistortion unit is configured to perform, according to a predistortion coefficient calculated by the coefficient calculating unit, analog predistortion processing on a low-frequency or intermediate-frequency analog signal, and output a low-frequency or intermediate-frequency predistortion analog signal;
the feedback channel is configured to perform down-conversion on a part of a distortionless radio frequency signal output after an amplifier amplifies a predistortion radio frequency signal output by the analog predistortion unit after up-conversion, and output a low-frequency or intermediate-frequency feedback analog signal;
the analog-to-digital converter is configured to perform analog-to-digital conversion on the low-frequency or intermediate-frequency feedback analog signal output by the feedback channel, and output a feedback digital signal;
the second analog-to-digital converter is configured to perform analog-to-digital conversion on a part of the low-frequency or intermediate-frequency analog signal, to obtain a digital signal; and
the coefficient calculating unit is configured to calculate a predistortion coefficient according to the digital signal obtained by the second analog-to-digital converter and the feedback digital signal output by the analog-to-digital converter, and transfer the calculated predistortion coefficient to the analog predistortion unit.

It can be understood that, a part of modules in the signal transmission system and the digital analog predistortion apparatus 330 provided in the embodiment of the present invention are function modules, and several modules can be combined into a module according to needs of an actual application scenario.

The embodiment of the present invention further provides a signal transmission method, which may include:
performing digital-to-analog conversion on a digital signal to be transmitted; filtering out a digital mirror in a signal obtained after the digital-to-analog conversion, to obtain a low-frequency or intermediate-frequency analog signal; performing analog predistortion processing on the obtained low-frequency or intermediate-frequency analog signal according to a predistortion coefficient (the predistortion coefficient used at this time is calculated previously or preconfigured), to obtain a low-frequency or
intermediate-frequency predistortion analog signal; performing up-conversion on the low-frequency or intermediate-frequency predistortion analog signal, to obtain a predistortion radio frequency signal; amplifying the obtained predistortion radio frequency signal, to obtain a distortionless radio frequency signal; and performing radio frequency filtering on the obtained distortionless radio frequency signal and transmitting the distortionless radio frequency signal after the radio frequency filtering through an antenna.

It can be seen from the above description that, in this embodiment, digital-to-analog conversion is firstly performed on a digital signal to be transmitted; a digital mirror in a signal obtained after the digital-to-analog conversion is filtered out, to obtain a low-frequency or intermediate-frequency analog signal; analog predistortion processing is performed on the obtained low-frequency or intermediate-frequency analog signal according to a predistortion coefficient, to obtain a low-frequency or intermediate-frequency predistortion analog signal; then up-conversion is performed on the low-frequency or intermediate-frequency predistortion analog signal, to obtain a predistortion radio frequency signal; the obtained predistortion radio frequency signal is amplified, to obtain a distortionless radio frequency signal; and radio frequency filtering is performed on the obtained distortionless radio frequency signal and the distortionless radio frequency signal after the radio frequency filtering is transmitted through an antenna, so the bandwidth requirement for components such as the DAC and the reconstruction filter is relatively low, which helps reduce the device cost.

In an application scenario, the method further includes: performing down-conversion on a part of the obtained distortionless radio frequency signal, to obtain a low-frequency or intermediate-frequency feedback analog signal; performing analog-to-digital conversion on the obtained low-frequency or intermediate-frequency feedback analog signal, to obtain a feedback digital signal; performing analog-to-digital conversion on a part of the low-frequency or intermediate-frequency analog signal, to obtain a digital signal; and calculating a predistortion coefficient according to the obtained digital signal and feedback digital signal.

Referring to FIG. 3-c, specifically the following steps may be included.
B1: Perform digital-to-analog conversion on a digital signal to be transmitted;
B2: Filter out a digital mirror in a signal obtained after the digital-to-analog conversion, to obtain a low-frequency or intermediate-frequency analog signal;
B3: Perform analog predistortion processing on the obtained low-frequency or intermediate-frequency analog signal according to a predistortion coefficient (the predistortion coefficient used at this time is calculated previously or preconfigured), to obtain a low-frequency or intermediate-frequency predistortion analog signal;
B4: Perform up-conversion on the low-frequency or intermediate-frequency predistortion analog signal, to obtain a predistortion radio frequency signal;
B5: Amplify the obtained predistortion radio frequency signal, to obtain a distortionless radio frequency signal;
B6: Perform radio frequency filtering on the obtained distortionless radio frequency signal and transmit the distortionless radio frequency signal after the radio frequency filtering through an antenna;
B7: Perform down-conversion on a part of the obtained distortionless radio frequency signal, to obtain a low-frequency or intermediate-frequency feedback analog signal;
B8: Perform analog-to-digital conversion on the obtained low-frequency or intermediate-frequency feedback analog signal, to obtain a feedback digital signal;
B9: Perform analog-to-digital conversion on a part of the low-frequency or intermediate-frequency analog signal, to obtain a digital signal; and
B10: Calculate a predistortion coefficient according to the obtained digital signal and feedback digital signal.

It can be understood that, step B9 can be executed at any moment after step B2 and before step BI0, and steps B7 to B10 can be executed at any moment after step B5, for example, can be executed before step B6.

It can be understood that, the foregoing signal transmission method may be specifically implemented based on the signal transmission systems shown in FIG. 3-a and FIG. 3-b, and for the specific implementation procedure, reference is made to the description of a related part, which is not described herein again.

It can be seen from the above description that, in this embodiment, firstly a digital signal to be transmitted is processed by using a DAC and a reconstruction filter, to obtain a low-frequency or intermediate-frequency analog signal, then a digital analog predistortion apparatus performs predistortion processing on the obtained low-frequency or intermediate-frequency analog signal, and then the low-frequency or intermediate-frequency analog signal after the predistortion processing is up-converted, amplified, and output, so the bandwidth requirement for components such as the DAC and the reconstruction filter is relatively low, which helps reduce the device cost. It should be noted that, for brevity, the above method embodiments are represented as a series of actions. But those skilled in the art should appreciate that the present invention is not limited to the order of the described actions, because according to the present invention, some steps may adopt other orders or occur simultaneously. It should be further understood by persons skilled in the art that the described embodiments all belong to exemplary embodiments, and the involved actions and modules are not necessarily required by the present invention.

In the foregoing embodiments, descriptions of the embodiments have different emphases, and as for parts that are not described in detail in one embodiment, reference may be made to the relevant description of the other embodiments.

To sum up, in a technical solution provided in the embodiments of the present invention, firstly a digital signal to be transmitted is processed by using a DAC, a reconstruction filter, and an up-converter, to obtain a radio frequency signal, then a digital analog predistortion apparatus performs predistortion processing on the obtained radio frequency signal, and then the radio frequency signal after the predistortion processing is amplified and output, so the bandwidth requirement for components such as the DAC, the reconstruction filter, and the up-converter is relatively low, which helps reduce the device cost.

In another technical solution provided in the embodiments of the present invention, firstly a digital signal to be transmitted is processed by using a DAC and a reconstruction filter, to obtain a low-frequency or intermediate-frequency analog signal, then a digital analog predistortion apparatus performs predistortion processing on the obtained low-frequency or intermediate-frequency analog signal, and then the low-frequency or intermediate-frequency analog signal after the predistortion processing is up-converted, amplified, and output, so the bandwidth requirement for components such as the DAC and the reconstruction filter is relatively low, which helps reduce the device cost. A person of ordinary skill in the art may understand that all or a part of the steps of the methods in the foregoing embodiments may be implemented by a program instructing relevant hardware. The program may be stored in a computer readable storage medium. The storage medium may include: a read-only memory, a random access memory, a magnetic disk, or an optical disc. The invention is solely defined by the appended claims.

## Claims

1. A signal transmission system, comprising:
a first digital-to-analog converter (310), a reconstruction filter (320), a digital analog predistortion apparatus (330), an up-converter (340), an amplifier (350), and a radio frequency filter (360),
wherein the first digital-to-analog converter (310) is configured to perform digital-to-analog conversion on a digital signal to be transmitted;
the reconstruction filter (320) is configured to filter out a digital mirror in a signal output by the digital-to-analog converter (310) after the digital-to-analog conversion, and output a low-frequency or intermediate-frequency analog signal;
the digital analog predistortion apparatus (330) is configured to perform, according to a predistortion coefficient, analog predistortion processing on the low-frequency or intermediate-frequency analog signal output by the reconstruction filter (320), and output a low-frequency or intermediate-frequency predistortion analog signal;
the up-converter (340) is configured to perform up-conversion on the low-frequency or intermediate-frequency predistortion analog signal output by the digital analog predistortion apparatus, and output a predistortion radio frequency signal;
the amplifier (350) is configured to amplify the predistortion radio frequency signal output by the up-converter, and output a distortionless radio frequency signal; and
the radio frequency filter (360) is configured to perform radio frequency filtering on the distortionless radio frequency signal output by the amplifier and transfer the distortionless radio frequency signal after the radio frequency filtering to an antenna for transmission;
the digital analog predistortion apparatus (330) is further configured to perform down-conversion on a part of the distortionless radio frequency signal output by the amplifier, to obtain a low-frequency or intermediate-frequency feedback analog signal, and perform analog-to-digital conversion on the obtained low-frequency or intermediate-frequency feedback analog signal, to obtain a feedback digital signal; perform analog-to-digital conversion on a part of the low-frequency or intermediate-frequency analog signal output by the reconstruction filter, to obtain a digital signal; and calculate a predistortion coefficient according to the obtained digital signal and the feedback digital signal;
wherein
the digital analog predistortion apparatus (330) comprises: a coefficient calculating unit (333), an analog predistortion unit (331), a feedback channel (334), an analog-to-digital converter (335), and a second analog-to-digital converter (332),
wherein the analog predistortion unit (331) is configured to perform, according to a predistortion coefficient calculated by the coefficient calculating unit (333), analog predistortion processing on the low-frequency or intermediate-frequency analog signal output by the reconstruction filter (320), and output a low-frequency or intermediate-frequency predistortion analog signal;
the feedback channel (334) is configured to perform down-conversion on a part of the distortionless radio frequency signal output by the amplifier (350), and output a low-frequency or intermediate-frequency feedback analog signal;
the analog-to-digital converter (335) is configured to perform analog-to-digital conversion on the low-frequency or intermediate-frequency feedback analog signal output by the feedback channel, and output a feedback digital signal;
the second analog-to-digital converter (332) is configured to perform analog-to-digital conversion on a part of the low-frequency or intermediate-frequency analog signal output by the reconstruction filter, to obtain a digital signal; and
the coefficient calculating unit (333) is configured to calculate a predistortion coefficient according to the digital signal obtained by the second analog-to-digital converter (332) and the feedback digital signal output by the analog-to-digital converter (335), and transfer the calculated predistortion coefficient to the analog predistortion unit (331).

2. A digital analog predistortion apparatus, comprising:
a coefficient calculating unit (333), an analog predistortion unit (331), a feedback channel (334), an analog-to-digital converter (335), and a second analog-to-digital converter (332),
wherein the analog predistortion unit (331) is configured to perform, according to a predistortion coefficient calculated by the coefficient calculating unit (333), analog predistortion processing on a low-frequency or intermediate-frequency analog signal, and output a low-frequency or intermediate-frequency predistortion analog signal;
the feedback channel (334) is configured to perform down-conversion on a part of a distortionless radio frequency signal output after an amplifier (350) amplifies a predistortion radio frequency signal output by the analog predistortion unit (331) after up-conversion, and output a low-frequency or intermediate-frequency feedback analog signal;
the analog-to-digital converter (335) is configured to perform analog-to-digital conversion on the low-frequency or intermediate-frequency feedback analog signal output by the feedback channel (334), and output a feedback digital signal;
the second analog-to-digital converter (332) is configured to perform analog-to-digital conversion on a part of the low-frequency or intermediate-frequency analog signal, to obtain a digital signal; and
the coefficient calculating unit (333) is configured to calculate a predistortion coefficient according to the digital signal obtained by the second analog-to-digital converter (332) and the feedback digital signal output by the analog-to-digital converter (335), and transfer the calculated predistortion coefficient to the analog predistortion unit (331).

3. A signal transmission method, comprising:
performing (B1) digital-to-analog conversion on a digital signal to be transmitted;
filtering out (B2) a digital mirror in a signal obtained after the digital-to-analog conversion, to obtain a low-frequency or intermediate-frequency analog signal;
performing (B3) analog predistortion processing on the obtained low-frequency or intermediate-frequency analog signal according to a predistortion coefficient, to obtain a low-frequency or intermediate-frequency predistortion analog signal;
performing (B4) up-conversion on the low-frequency or intermediate-frequency predistortion analog signal, to obtain a predistortion radio frequency signal;
amplifying (B5) the obtained predistortion radio frequency signal, to obtain a distortionless radio frequency signal; and
performing (B6) radio frequency filtering on the obtained distortionless radio frequency signal and transmitting the distortionless radio frequency signal after the radio frequency filtering through an antenna;
performing (B7) down-conversion on a part of the obtained distortionless radio frequency signal, to obtain a low-frequency or intermediate-frequency feedback analog signal; performing analog-to-digital conversion on the obtained low-frequency or intermediate-frequency feedback analog signal, to obtain a feedback digital signal; performing analog-to-digital conversion on a part of the low-frequency or intermediate-frequency analog signal, to obtain a digital signal; and calculating a predistortion coefficient according to the obtained digital signal and feedback digital signal.

## Patentansprüche

1. Signalübertragungssystem, umfassend:
einen ersten Digital-zu-Analog-Wandler (310), ein Rekonstruktionsfilter (320), eine Digitalanalogvorverzerrungsvorrichtung (330), einen Aufwärtswandler (340), einen Verstärker (350) und ein Funkfrequenzfilter (360),
wobei der erste Digital-zu-Analog-Wandler (310) konfiguriert ist zum Durchführen von Digital-zu-Analog-Umwandlung an einem zu übertragenden Digitalsignal;
das Rekonstruktionsfilter (320) konfiguriert ist zum Herausfiltern einer digitalen Spiegelung in einem durch den Digital-zu-Analog-Wandler (310) ausgegebenen Signal nach der Digital-zu-Analog-Umwandlung und zum Ausgeben eines Niederfrequenz- oder Zwischenfrequenz-Analogsignals;
die Digitalanalogvorverzerrungsvorrichtung (330) konfiguriert ist zum Durchführen, gemäß einem Vorverzerrungskoeffizienten, von Analogvorverzerrungsverarbeitung an dem durch das Rekonstruktionsfilter (320) ausgegebenen Niederfrequenz- oder Zwischenfrequenz-Analogsignal und zum Ausgeben eines Niederfrequenz- oder Zwischenfrequenz-V orverzerrungsanalogsignals;
der Aufwärtswandler (340) konfiguriert ist zum Durchführen von Aufwärtsumwandlung an dem durch die Digitalanalogvorverzerrungsvorrichtung ausgegebenen Niederfrequenz- oder Zwischenfrequenz-Vorverzerrungsanalogsignal und zum Ausgeben eines Vorverzerrungsfunkfrequenzsignals;
der Verstärker (350) konfiguriert ist zum Verstärken des durch den Aufwärtswandler ausgegebenen Vorverzerrungsfunkfrequenzsignals und zum Ausgeben eines verzerrungsfreien Funkfrequenzsignals; und
das Funkfrequenzfilter (360) konfiguriert ist zum Durchführen von Funkfrequenzfiltern an dem durch den Verstärker ausgegebenen verzerrungsfreien Funkfrequenzsignal und zum Übergeben des verzerrungsfreien Funkfrequenzsignals nach dem Funkfrequenzfiltern an eine Antenne für Übertragung;
die Digitalanalogvorverzerrungsvorrichtung (330) ferner konfiguriert ist zum Durchführen von Abwärtsumwandlung an einem Teil des durch den Verstärker ausgegebenen verzerrungsfreien Funkfrequenzsignals, um ein Niederfrequenz- oder Zwischenfrequenz-Rückmeldungsanalogsignal zu erlangen, und zum Durchführen von Analog-zu-Digital-Umwandlung an dem erlangten Niederfrequenz- oder Zwischenfrequenz-Rückmeldungsanalogsignal, um ein Rückmeldungsdigitalsignal zu erlangen; zum Durchführen von Analog-zu-Digital-Umwandlung an einem Teil des durch das Rekonstruktionsfilter ausgegebenen Niederfrequenz- oder Zwischenfrequenz-Analogsignals, um ein Digitalsignal zu erlangen; und zum Berechnen eines Vorverzerrungskoeffizienten gemäß dem erlangten Digitalsignal und dem Rückmeldungsdigitalsignal;
wobei
die Digitalanalogvorverzerrungsvorrichtung (330) umfasst: eine Koeffizientenberechnungseinheit (333), eine Analogvorverzerrungseinheit (331), einen Rückmeldungskanal (334), einen Analog-zu-Digital-Wandler (335) und einen zweiten Analog-zu-Digital-Wandler (332),
wobei die Analogvorverzerrungseinheit (331) konfiguriert ist zum Durchführen, gemäß einem durch die Koeffizientenberechnungseinheit (333) berechneten Vorverzerrungskoeffizienten, von Analogvorverzerrungsverarbeitung an dem durch das Rekonstruktionsfilter (320) ausgegebenen Niederfrequenz- oder Zwischenfrequenz-Analogsignal und zum Ausgeben eines Niederfrequenz- oder Zwischenfrequenz-Vorverzerrungsanalogsignals;
der Rückmeldungskanal (334) konfiguriert ist zum Durchführen von Abwärtsumwandlung an einem Teil des durch den Verstärker (350) ausgegebenen verzerrungsfreien Funkfrequenzsignals und zum Ausgeben eines Niederfrequenz- oder Zwischenfrequenz-Rückmeldungsanalogsignals;
der Analog-zu-Digital-Wandler (335) konfiguriert ist zum Durchführen von Analog-zu-Digital-Umwandlung an dem durch den Rückmeldungskanal ausgegebenen Niederfrequenz- oder Zwischenfrequenz-Rückmeldungsanalogsignal und zum Ausgeben eines Rückmeldungsdigitalsignals;
der zweite Analog-zu-Digital-Wandler (332) konfiguriert ist zum Durchführen von Analog-zu-Digital-Umwandlung an einem Teil des durch das Rekonstruktionsfilter ausgegebenen Niederfrequenz- oder Zwischenfrequenz-Analogsignals, um ein Digitalanalog zu erlangen; und
die Koeffizientenberechnungseinheit (333) konfiguriert ist zum Berechnen eines Vorverzerrungskoeffizienten gemäß dem durch den zweiten Analog-zu-Digital-Wandler (332) erlangten Digitalsignal und dem durch den Analog-zu-Digital-Wandler (335) ausgegebenen Rückmeldungsdigitalsignal und zum Übergeben des berechneten Vorverzerrungskoeffizienten an die Analogvorverzerrungseinheit (331).

2. Digitalsignalvorverzerrungsvorrichtung, umfassend:
eine Koeffizientenberechnungseinheit (333), eine Analogvorverzerrungseinheit (331), einen Rückmeldungskanal (334), einen Analog-zu-Digital-Wandler (335) und einen zweiten Analog-zu-Digital-Wandler (332),
wobei die Analogvorverzerrungseinheit (331) konfiguriert ist zum Durchführen, gemäß einem durch die Koeffizientenberechnungseinheit (333) berechneten Vorverzerrungskoeffizienten, von Analogvorverzerrungsverarbeitung an einem Niederfrequenz- oder Zwischenfrequenz-Analogsignal und zum Ausgeben eines Niederfrequenz- oder Zwischenfrequenz-Vorverzerrungsanalogsignals;
der Rückmeldungskanal (334) konfiguriert ist zum Durchführen von Abwärtsumwandlung an einem Teil eines verzerrungsfreien Funkfrequenzsignals, ausgegeben, nachdem ein Verstärker (350) ein durch die Analogvorverzerrungseinheit (331) ausgegebenes Vorverzerrungsfunkfrequenzsignal verstärkt, und zum Ausgeben eines Niederfrequenz- oder Zwischenfrequenz-Rückmeldungsanalogsignals;
der Analog-zu-Digital-Wandler (335) konfiguriert ist zum Durchführen von Analog-zu-Digital-Umwandlung an dem durch den Rückmeldungskanal (334) ausgegebenen Niederfrequenz- oder Zwischenfrequenz-Rückmeldungsanalogsignal und zum Ausgeben eines Rückmeldungsdigitalsignals;
der zweite Analog-zu-Digital-Wandler (332) konfiguriert ist zum Durchführen von Analog-zu-Digital-Umwandlung an einem Teil des Niederfrequenz- oder Zwischenfrequenz-Analogsignals, um ein Digitalsignal zu erlangen; und
die Koeffizientenberechnungseinheit (333) konfiguriert ist zum Berechnen eines Vorverzerrungskoeffizienten gemäß dem durch den zweiten Analog-zu-Digital-Wandler (332) erlangten Digitalsignal und dem durch den Analog-zu-Digital-Wandler (335) ausgegebenen Rückmeldungsdigitalsignals und zum Übergeben des berechneten Vorverzerrungskoeffizienten an die Analogvorverzerrungseinheit (331).

3. Signalübertragungsverfahren, umfassend:
Durchführen (B1) von Digital-zu-Analog-Umwandlung an einem zu übertragenden Digitalsignal;
Herausfiltern (B2) einer digitalen Spiegelung in einem nach der Digital-zu-Analog-Umwandlung erlangten Signal, um ein Niederfrequenz- oder Zwischenfrequenz-Analogsignal zu erlangen;
Durchführen (B3) von Analogvorverzerrungsverarbeitung an dem erlangten Niederfrequenz- oder Zwischenfrequenz-Analogsignal gemäß einem Vorverzerrungskoeffizienten, um ein Niederfrequenz- oder Zwischenfrequenz-Vorverzerrungsanalogsignal zu erlangen;
Durchführen (B4) von Aufwärtsumwandlung an dem Niederfrequenz- oder Zwischenfrequenz-Vorverzerrungsanalogsignal, um ein Vorverzerrungsfunkfrequenzsignal zu erlangen;
Verstärken (B5) des erlangten Vorverzerrungsfunkfrequenzsignals, um ein verzerrungsfreies Funkfrequenzsignal zu erlangen; und
Durchführen (B6) von Funkfrequenzfiltern an dem erlangten verzerrungsfreien Funkfrequenzsignal und Übertragen des verzerrungsfreien Funkfrequenzsignals nach dem Funkfrequenzfiltern durch eine Antenne;
Durchführen (B7) von Abwärtsumwandlung an einem Teil des erlangten verzerrungsfreien Funkfrequenzsignals, um ein Niederfrequenz- oder Zwischenfrequenz-Rückmeldungsanalogsignal zu erlangen; Durchführen von Analog-zu-Digital-Umwandlung an dem erlangten Niederfrequenz- oder Zwischenfrequenz-Rückmeldungsanalogsignal, um ein Rückmeldungsdigitalsignal zu erlangen; Durchführen von Analog-zu-Digital-Umwandlung an einem Teil des Niederfrequenz- oder Zwischenfrequenz-Analogsignals, um ein Digitalsignal zu erlangen; und Berechnen eines Vorverzerrungskoeffizienten gemäß dem erlangten Digitalsignal und Rückmeldungsdigitalsignal.

## Revendications

1. Système de transmission de signal, comprenant :
un premier convertisseur numérique-analogique (310), un filtre de reconstruction (320), un appareil de prédistorsion analogique numérique (330), un convertisseur élévateur (340), un amplificateur (350) et un filtre radiofréquence (360),
le premier convertisseur numérique-analogique (310) étant configuré pour réaliser une conversion numérique-analogique sur un signal numérique à transmettre ;
le filtre de reconstruction (320) étant configuré pour éliminer par filtrage un miroir numérique dans un signal fourni en sortie par le convertisseur numérique-analogique (310) suite à la conversion numérique-analogique, et fournir en sortie un signal analogique basse fréquence ou de fréquence intermédiaire ;
l'appareil de prédistorsion analogique numérique (330) étant configuré pour réaliser, selon un coefficient de prédistorsion, un traitement de prédistorsion analogique sur le signal analogique basse fréquence ou de fréquence intermédiaire fourni en sortie par le filtre de reconstruction (320), et fournir en sortie un signal analogique à prédistorsion basse fréquence ou de fréquence intermédiaire ;
le convertisseur élévateur (340) étant configuré pour réaliser une conversion-élévation sur le signal analogique à prédistorsion basse fréquence ou de fréquence intermédiaire fourni en sortie par l'appareil de prédistorsion analogique numérique, et fournir en sortie un signal radiofréquence à prédistorsion ;
l'amplificateur (350) étant configuré pour amplifier le signal radiofréquence à prédistorsion fourni en sortie par le convertisseur élévateur, et fournir en sortie un signal radiofréquence sans distorsion ; et
le filtre radiofréquence (360) étant configuré pour réaliser un filtrage radiofréquence sur le signal radiofréquence sans distorsion fourni en sortie par l'amplificateur et transférer le signal radiofréquence sans distorsion suite au filtrage radiofréquence à une antenne en vue de sa transmission ;
l'appareil de prédistorsion analogique numérique (330) étant configuré en outre pour réaliser une conversion-abaissement sur une partie du signal radiofréquence sans distorsion fourni en sortie par l'amplificateur aux fins d'obtenir un signal analogique de retour basse fréquence ou de fréquence intermédiaire, et réaliser une conversion analogique-numérique sur le signal analogique de retour basse fréquence ou de fréquence intermédiaire obtenu aux fins d'obtenir un signal numérique de retour ; réaliser une conversion analogique-numérique sur une partie du signal analogique basse fréquence ou de fréquence intermédiaire fourni en sortie par le filtre de reconstruction aux fins d'obtenir un signal numérique ; et calculer un coefficient de prédistorsion selon le signal numérique obtenu et le signal numérique de retour ;
l'appareil de prédistorsion analogique numérique (330) comprenant : une unité de calcul de coefficient (333), une unité de prédistorsion analogique (331), un canal de retour (334), un convertisseur analogique-numérique (335) et un deuxième convertisseur analogique-numérique (332),
l'unité de prédistorsion analogique (331) étant configurée pour réaliser, selon un coefficient de prédistorsion calculé par l'unité de calcul de coefficient (333), un traitement de prédistorsion analogique sur le signal analogique basse fréquence ou de fréquence intermédiaire fourni en sortie par le filtre de reconstruction (320), et fournir en sortie un signal analogique à prédistorsion basse fréquence ou de fréquence intermédiaire ;
le canal de retour (334) étant configuré pour réaliser une conversion-abaissement sur une partie du signal radio fréquence sans distorsion fourni en sortie par l'amplificateur (350), et fournir en sortie un signal analogique de retour basse fréquence ou de fréquence intermédiaire ;
le convertisseur analogique-numérique (335) étant configuré pour réaliser une conversion analogique-numérique sur le signal analogique de retour basse fréquence ou de fréquence intermédiaire fourni en sortie par le canal de retour, et fournir en sortie un signal numérique de retour ;
le deuxième convertisseur analogique-numérique (332) étant configuré pour réaliser une conversion analogique-numérique sur une partie du signal analogique basse fréquence ou de fréquence intermédiaire fourni par le filtre de reconstruction aux fins d'obtenir un signal numérique ; et
l'unité de calcul de coefficient (333) étant configurée pour calculer un coefficient de prédistorsion selon le signal numérique obtenu par le deuxième convertisseur analogique-numérique (332) et le signal numérique de retour fourni en sortie par le convertisseur analogique-numérique (335), et transférer le coefficient de prédistorsion calculé à l'unité de prédistorsion analogique (331).

2. Appareil de prédistorsion analogique numérique, comprenant :
une unité de calcul de coefficient (333), une unité de prédistorsion analogique (331), un canal de retour (334), un convertisseur analogique-numérique (335) et un deuxième convertisseur analogique-numérique (332),
l'unité de prédistorsion analogique (331) étant configurée pour réaliser, selon un coefficient de prédistorsion calculé par l'unité de calcul de coefficient (333), un traitement de prédistorsion analogique sur un signal analogique basse fréquence ou de fréquence intermédiaire, et fournir en sortie un signal analogique à prédistorsion basse fréquence ou de fréquence intermédiaire ;
le canal de retour (334) étant configuré pour réaliser une conversion-abaissement sur une partie d'un signal radiofréquence sans distorsion fourni en sortie suite à une amplification, par un amplificateur (350), d'un signal radiofréquence à prédistorsion fourni en sortie par l'unité de prédistorsion analogique (331) suite à une conversion-élévation, et fournir en sortie un signal analogique de retour basse fréquence ou de fréquence intermédiaire ;
le convertisseur analogique-numérique (335) étant configuré pour réaliser une conversion analogique-numérique sur le signal analogique de retour basse fréquence ou de fréquence intermédiaire fourni en sortie par le canal de retour (334), et fournir en sortie un signal numérique de retour ;
le deuxième convertisseur analogique-numérique (332) étant configuré pour réaliser une conversion analogique-numérique sur une partie du signal analogique basse fréquence ou de fréquence intermédiaire aux fins d'obtenir un signal numérique ; et
l'unité de calcul de coefficient (333) étant configurée pour calculer un coefficient de prédistorsion selon le signal numérique obtenu par le deuxième convertisseur analogique-numérique (332) et le signal numérique de retour fourni en sortie par le convertisseur analogique-numérique (335), et transférer le coefficient de prédistorsion calculé à l'unité de prédistorsion analogique (331).

3. Procédé de transmission de signal, comprenant les étapes suivantes :
réalisation (B1) d'une conversion numérique-analogique sur un signal numérique à transmettre ;
élimination par filtrage (B2) d'un miroir numérique dans un signal obtenu suite à la conversion numérique-analogique aux fins d'obtenir un signal analogique basse fréquence ou de fréquence intermédiaire ;
réalisation (B3), selon un coefficient de prédistorsion, d'un traitement de prédistorsion analogique sur le signal analogique basse fréquence ou de fréquence intermédiaire obtenu aux fins d'obtenir un signal analogique à prédistorsion basse fréquence ou de fréquence intermédiaire ;
réalisation (B4) d'une conversion-élévation sur le signal analogique à prédistorsion basse fréquence ou de fréquence intermédiaire aux fins d'obtenir un signal radiofréquence à prédistorsion ;
amplification (B5) du signal radiofréquence à prédistorsion aux fins d'obtenir un signal radiofréquence sans distorsion ; et
réalisation (B6) d'un filtrage radiofréquence sur le signal radiofréquence sans distorsion obtenu et transmission du signal radiofréquence sans distorsion suite au filtrage radiofréquence au moyen d'une antenne ;
réalisation (B7) d'une conversion-abaissement sur une partie du signal radiofréquence sans distorsion obtenu aux fins d'obtenir un signal analogique de retour basse fréquence ou de fréquence intermédiaire ; réalisation d'une conversion analogique-numérique sur le signal analogique de retour basse fréquence ou de fréquence intermédiaire obtenu aux fins d'obtenir un signal numérique de retour ; réalisation d'une conversion analogique-numérique sur une partie du signal analogique basse fréquence ou de fréquence intermédiaire aux fins d'obtenir un signal numérique ; et calcul d'un coefficient de prédistorsion selon le signal numérique obtenu et le signal numérique de retour.
